# EUROPÄISCHE PATENTSCHRIFT

(11) **EP 0 541 905 B1**
(45) Veröffentlichungstag und Bekanntmachung des Hinweises auf die Patenterteilung: **08.12.1999**
(21) Anmeldenummer: 92112665.2
(22) Anmeldetag: 24.07.1992
(51) Int. Cl.: G03F 7/022

(54) **Lichtempfindliches Gemisch mit o-Naphthochinondiazidsulfonsäureestern und damit hergestelltes Aufzeichnungsmaterial**
Light-sensitive mixture containing o-naphthoquinone diazide sulfonic acid esters and recording material prepared therefrom
Mélange photosensible contenant des esters d'acide o-naphto quinone diazide sulfonique et matériel d'enregistrement préparé avec ce mélange

(30) Priorität: 13.11.1991 DE 4137325
(43) Veröffentlichungstag der Anmeldung: 19.05.1993
(73) Patentinhaber: Agfa-Gevaert AG, 51373 Leverkusen (DE)
(72) Erfinder: Scheler, Siegfried, Dr., W-6200 Wiesbaden-Naurod (DE); Elsässer, Andreas, Dr., W-6270 Idstein (DE); Buhr, Gerhard, Dr., W-6240 Königstein (DE); Bergmann, Klaus, W-6500 Mainz-Bretzenheim (DE); Zahn, Wolfgang, Dr., W-6228 Eltville 2 (DE)

(56) Entgegenhaltungen:
- EP-A- 0 052 788
- EP-A- 0 488 712
- JP-A- 1 309 052

## Beschreibung

Die Erfindung betrifft ein positiv arbeitendes lichtempfindliches Gemisch, das ein wasserunlösliches, in wäßrig-alkalischen Lösungen lösliches oder mindestens quellbares harzartiges Bindemittel und als lichtempfindliche Verbindung einen o-Naphthochinondiazidsulfonsäureester eines Diacylhexahydroxydiphenylmethans enthält und das zur Herstellung lichtempfindlicher Materialien, z.B. Flachdruckplatten und Photoresists, bestimmt ist.

Lichtempfindliche Verbindungen des angegebenen Typs sind aus der EP-B 0 052 788 (=US-A 4 407 926), bekannt. Es handelt sich hierbei um vollständig mit 1,2-Naphthochinon-2-diazid-4- oder 1,2-Naphthochinon-2-diazid-5-sulfonsäure verestertes Diacylhexahydroxydiphenylmethan. Die mit diesen Verbindungen hergestellten Druckplatten besitzen eine für die Praxis ausreichende Lichtempfindlichkeit, eine verbesserte Resistenz gegenüber alkalischen Entwicklern und solchen organischen Lösemitteln, wie sie üblicherweise während der Kopierarbeiten und während des Druckvorganges an den Druckmaschinen verwendet werden.

Ein Nachteil dieser Verbindungen ist ihre für manche Zwecke nicht ausreichende Löslichkeit in für die Beschichtung von Metall- oder Kunststoffträgern verwendeten organischen Lösemitteln, wie z.B. Glykol-monoether, wie Glykolmonomethyl-, -monoethyl- oder -monopropylether, Carbonsäureester, wie Ethyl- oder Butylacetat, Ketone, wie Methylethylketon, Cyclopentanon oder Cyclohexanon, sowie aromatische Kohlenwasserstoffe, wie Toluol oder Xylol. Ein weiterer Nachteil ist, daß Kopierschichten, die diese Verbindungen als lichtempfindliche Komponenten enthalten, im belichteten Zustand nur mit verhältnismäßig starken wäßrig-alkalischen Lösungen schnell entwickelt werden können. Mit den heute aus ökologischen Gründen im zunehmenden Maße bevorzugten wäßrigen, schwach, alkalischen Entwicklern können solche Kopierschichten nicht mit ausreichender praxisgerechter Geschwindigkeit entwickelt werden.

Bei den aus der DE-C 938 233 (= GB-A 739 654) und der US-A 3 802 885 bekannten lichtempfindlichen Verbindungen handelt es sich um teilweise oder vollständig mit o-Naphthochinondiazidsulfonsäuren veresterte Di- oder Trihydroxybenzophenone.

Diese Verbindungen lösen sich gut in den für die Beschichtung von metallischen oder nichtmetallischen Trägermaterialien verwendeten üblichen Lösemitteln und weisen eine relativ hohe Lichtempfindlichkeit auf. Belichtete Kopierschichten aus diesen Verbindungen zusammen mit wäßrig alkalisch löslichen Bindemitteln, z.B. Novolaken, kann man auch mit wäßrigen schwach alkalischen Lösungen entwickeln. Die Kopierschichten zeigen jedoch in der Regel eine nicht ausreichende Entwicklerresistenz der unbelichteten Schichtbestandteile. Außerdem werden diese Schichten während des Druckvorganges bei der Verwendung von alkoholhaltigen Feuchtwässern mehr oder weniger stark angegriffen. Für die praktische Anwendung ist die Alkoholresistenz solcher Schichten deshalb in vielen Fällen nicht ausreichend.

Weitere Ester aus o-Naphthochinondiazidsulfonsäuren und aromatischen Polyhydroxyverbindungen sind aus der DE-C 11 18 606 (= GB-A 935 250) bekannt. Unter anderem werden als phenolische Komponenten auch Derivate des Diphenylmethans genannt. Die Polyhydroxydiphenylmethanderivate sind jedoch nicht vollständig verestert, so daß sie noch mindestens eine freie Hydroxylgruppe enthalten. Verbindungen dieser Art sind für manche Zwecke in den für die Beschichtung von Trägermaterialien üblichen Lösemitteln nicht ausreichend löslich. Ihre Lichtempfindlichkeit ist für die praktische Anwendung im allgemeinen ausreichend, nicht jedoch die Alkoholresistenz der mit solchen Verbindungen hergestellten lichtempfindlichen Kopierschichten. Der technische Einsatz dieser Verbindungen ist deshalb nur sehr begrenzt möglich.

Aus der EP-A 0 440 238 ist ein Photoresistgemisch bekannt, das neben einem in wäßrig-alkalischen Lösungen löslichen Polymer aromatische Polyhydroxyverbindungen enthält, die teilweise mit 1,2-Naphthochinon-2-diazid-4-oder -5-sulfonsäure verestert sind. In dem Gemisch können noch bis zu 30 Gew.-% an vollständig veresterten Polyhydroxyverbindungen enthalten sein. Die aromatischen Polyhydroxyverbindungen sind nur in einer komplexen Reaktionsfolge zugänglich. Demgegenüber sind die zuvor beschriebenen phenolischen Grundkörper, die den Ausgangspunkt der vorliegenden Erfindung bilden, bereits bekannt und leicht zugänglich.

In der JP-A 1-309 052 (= US-A 5 089 373) ist ein Photoresistgemisch offenbart, bestehend aus Cresol-Novolakharz und 5,5'-Diacetyl-2,3,4,2',3',4 -hexahydroxy-diphenylmethan, dessen Hydroxygruppen zu 72 % mit 1,2-Naphthochinon-2-diazid-5-sulfonsäure verestert sind.

In der älteren, nicht vorveröffentlichten EP-A 488 712, ist ein lichtempfindliches Gemisch beschrieben, das ein Novolakharz und ein 5,5'-Di(C₇-C₁₁)alkanoyl-2,3,4,2',3',4'-hexahydroxy-diphenylmethan, dessen Hydroxygruppen zu 60 bis 100 % mit 1,2-Naphthochinon-2-diazid-4-sulfonsäure verestert sind, enthält.

Es war Aufgabe der Erfindung, ein lichtempfindliches, positiv arbeitendes Gemisch mit einem o-Naphthochinondiazidsulfonsäureester als lichtempfindliche Verbindung vorzuschlagen, das hinsichtlich Lichtempfindlichkeit, Entwickelbarkeit mit wäßrigen, schwach alkalischen Lösungen und Alkoholresistenz der nichtbelichteten Schichtbestandteile den bisher bekannten Gemischen überlegen ist. Die damit hergestellten Photoresistschichten sollen sich in ihrer thermischen Stabilität besonders vorteilhaft gegenüber bisher verwendeten Photoresistschichten auszeichnen.

Gelöst wird die Aufgabe durch ein lichtempfindliches Gemisch, das ein wasserunlösliches, in wäßrig-alkalischen Lösungen lösliches oder mindestens quellbares polymeres Bindemittel und einen o-Naphthochinondiazidsulfonsäureester enthält, dadurch gekennzeichnet, daß der 1,2-Naphthochinon-2-diazidsulfonsäureester der allgemeinen Formel I entspricht, 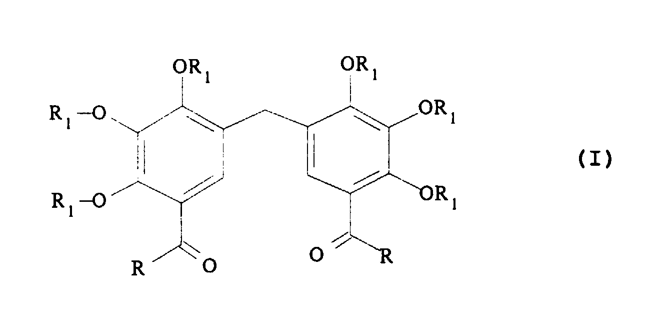 in der
- R: Wasserstoff, ein Alkyl- oder Arylrest,
- R₁: Wasserstoff, ein 1,2-Naphthochinon-2-diazid-4-, 1,2-Naphthochinon-2-diazid-5- oder 7-Methoxy-1,2-naphthochinon-2-diazid-4-sulfonylrest
bedeuten, wobei die Zahl der als R₁ definierten gleichartigen oder unterschiedlichen Naphthochinondiazidsulfonylreste im Molekül 1 bis 5 beträgt und der stöchiometrische Veresterungsgrad bei höchstens 65 % liegt, wenn R für einen Methylrest und R₁ für einen 1,2-Naphthochinon-2-diazid-5-sulfonylrest steht, und wobei 5,5'-Di(C₇-C₁₁)alkanoyl2,3,4,2',3',4'-hexahydroxy-diphenylmethane, deren Hydroxygruppen zu 60 bis 100 % mit 1,2-Naphthochinon-2-diazid-4sulfonsäure verestert sind, ausgeschlossen sind.

Die Erfindung betrifft weiterhin ein lichtempfindliches Gemisch der oben genannten Art, das zusätzlich mindestens einen vollständig mit o-Naphthochinondiazidsulfonsäure veresterte Verbindung der allgemeinen Formel I enthält.

Die Alkylreste R können geradkettig oder verzweigt sein und durch Halogenatome oder Alkoxygruppen substituiert sein. Sie enthalten 1 bis 20 Kohlenstoffatome. Die Arylreste R sind vorzugsweise einkernig und können durch Alkyl- oder Alkoxygruppen oder durch Halogenatome substituiert sein.

Von den Verbindungen der allgemeinen Formel I werden diejenigen bevorzugt, bei denen R ein Wasserstoffatom, ein Methyl- oder Phenylrest bedeutet.

Der stöchiometrische Veresterungsgrad liegt unter 100 %, vorzugsweise zwischen 40 und 95 %, besonders bevorzugt zwischen 45 bis 65 %. Wenn R ein Methylrest und R₁ ein 1,2-Naphthochinon-2-diazid-5-sulfonylrest bedeuten, ist der stöchiometrische Veresterungsgrad vorzugsweise zwischen 50 und 65 %. Im Falle, daß R ein Phenylrest und R₁ ein 1,2-Naphthochinon-2-diazid-5-sulfonylrest sind, ist der stöchiometrische Veresterungsgrad vorzugsweise 45 bis 60 %. Wenn R ein Methylrest und R₁ ein 7-Methoxy-1,2-naphthochinon-2-diazid-4-sulfonylrest bedeuten, liegt der stöchiometrische Veresterungsgrad vorzugsweise im Bereich von 70 bis 95 %.

Die erfindungsgemäßen Gemische zeichnen sich durch eine hohe Lichtempfindlichkeit, eine gute Entwicklerresistenz und eine gute Haftung auf metallischen oder nichtmetallischen Schichtträgern aus. Materialien mit diesen lichtempfindlichen Gemischen zeichnen sich außerdem aus durch ihre sehr schnelle Entwickelbarkeit mit wäßrigen, schwach-alkalischen Lösungen und durch eine sehr große Resistenz gegenüber den bei Druckvorgängen verwendeten alkoholhaltigen Feuchtwässern. Photoresists für die Mikrolithographie, die mit den erfindungsgemäßen lichtempfindlichen Gemischen hergestellt werden, zeichnen sich besonders durch sehr hohe Lichtempfindlichkeit und eine rückstandsfreie Entwicklung mit reinen Tetramethylammoniumhydroxid-Lösungen aus und verleihen den entwickelten Resiststrukturen eine hohe thermische Stabilität.

Herstellbar sind die Verbindungen der allgemeinen Formel I durch Umsetzung von 1 mol 5,5'- Diacyl-2,3,4,2',3',4'-hexahydroxy-diphenylmethan mit weniger als 6 mol eines aktivierten o-Naphthochinondiazidsulfonsäurederivats, z.B. eines o-Naphthochinondiazidsulfonsäurechlorids. So führt z.B. die Umsetzung von 1 mol 5,5'- Diacyl-2,3,4,2',3',4'-hexahydroxy-diphenylmethan mit 5 mol eines o-Naphthochinondiazidsulfonsäurechlorids zu einem einem Produkt mit einem stöchiometrischen Veresterungsgrad von 83,3 %.

Es können auch Gemische aus verschiedenen o-Naphthochinondiazidsulfonsäurechloriden eingesetzt werden. Die Durchführung der Veresterung erfolgt in einem organischen oder wäßrig-organischen Lösemittel in Gegenwart eines säurebindenden Mittels.

Geeignete Lösemittel sind beispielsweise Aceton, Acetonitril, Dioxan, Tetrahydrofuran, N-Methylpyrrolidon, Methylenchlorid u.a.

Der Säureakzeptor kann anorganisch sein, wie Natriumcarbonat oder Natriumhydrogencarbonat, oder organisch.

Von den organischen säurebindenden Mitteln sind insbesondere Natriumsalze von schwachen organischen Säure, wie Natriumacetat, tertiäre Amine, wie Triethylamin, Triethanolamin, N-Methylmorpholin, 1,4-Diazabicyclo[2.2.2]octan (^{(R)}Dabco) oder Pyridin bzw. Pyridinderivate geeignet.

Einige der erfindungsgemäßen o-Naphthochinondiazidsulfonsäureester von der angegebenen Formel I sind in der folgenden Tabelle 1 aufgeführt.

**Tabelle 1**

| Nr. | R | R₁ | VG/mol (%)¹⁾ |
|---|---|---|---|
| 1 | H | D₁ | 66,6 |
| 2 | CH₃ | D₁ | 45,0 |
| 3 | CH₃ | D₁ | 50,0 |
| 4 | CH₃ | D₁ | 56,6 |
| 5 | CH₃ | D₁ | 58,3 |
| 6 | CH₃ | D₁ | 60,0 |
| 7 | CH₃ | D₁ | 66,6 |
| 8 | CH₃ | D₁ | 83,3 |
| 9 | CH₃ | D₁ | 95,0 |
| 10 | CH₃ | D₂ | 45,0 |
| 11 | CH₃ | D₂ | 53,3 |
| 12 | CH₃ | D₂ | 75,5 |
| 13 | CH₃ | D₂ | 83,3 |
| 14 | CH₃ | D₃ | 55,0 |
| 15 | CH₃ | D₃ | 66,6 |
| 16 | CH₃ | D₃ | 83,3 |
| 17 | CH₃ | D₃ | 91,6 |
| 18 | C₂H₅ | D₁ | 66,6 |
| 19 | (CH₂)₆CH₃ | D₁ | 66,6 |
| 20 | (CH₂)₆CH₃ | D₁ | 83,3 |
| 21 | (CH₂)₁₆C₃ | D₁ | 58,3 |
| 22 | C₆H₅ | D₁ | 45,0 |
| 23 | C₆H₅ | D₁ | 50,0 |
| 24 | C₆H₅ | D₁ | 53,3 |
| 25 | C₆H₅ | D₁ | 60,0 |
| 26 | C₆H₅ | D₁ | 83,3 |
| 27 | C₆H₅ | D₁ | 95,0 |
| 28 | C₆H₅ | D₂ | 50,0 |
| 29 | C₆H₅ | D₁ | 83,3 |
| 30 | C₆H₅ | D₂ | 95,0 |
| 31 | C₆H₅ | D₃ | 45,0 |
| 32 | C₆H₅ | D₃ | 50,0 |
| 33 | C₆H₅ | D₃ | 66,6 |
| 34 | C₆H₅ | D₃ | 83,3 |
| 35 | C₆ H₅ | D₃ | 95,0 |

| | | | |
|---|---|---|---|
| D₁: 1,2-Naphthochinon-2-diazid-5-sulfonyl D₂: 1,2-Naphthochinon-2-diazid-4-sulfonyl D₃: 7-Methoxy-1,2-naphthochinon-2-diazid-4-sulfonyl 1) Stöchiometrischer Veresterungsgrad, bezogen auf die Anzahl (6) der Hydroxylgruppen im Molekül des phenolischen Grundkörpers | | | |

Die als Ausgangsmaterialien verwendeten 5,5'-Diacyl-2,3,4,2',3',4'-hexahydroxy-diphenylmethane erhält man in guter Ausbeute nach dem in der EP-B 0 052 788 (= US-A 4 407 926) beschriebenen Herstellungsverfahren durch Umsetzung der entsprechenden 4-Acylpyrogallole mit wäßriger Formalinlösung (38 Gew.-%) bei 80 - 100 °C in Gegenwart saurer Katalysatoren, wie Salzsäure oder p-Toluolsulfonsäure. Falls erforderlich, wird zur Auflösung der 4-Acylpyrogallole ein organisches Lösemittel, z.B. aliphatische kurzkettige Alkohole oder Glykolhalbether zugesetzt.

Die 4-Acylpyrogallole sind aus der Literatur bekannt und lassen sich nach den dort beschriebenen Verfahren oder in Analogie zu diesen herstellen. Einige dieser Verbindungen C₆H₂(OH)₃-CO-R sind in der folgenden Tabelle 2 zusammengestellt.

**Tabelle 2:**

| R | Fp (°C) | | Lit. |
|---|---|---|---|
| H | 159-161 | hellgelbe Blättchen | 1) |
| CH₃ | 167-169 | " " | 2) |
| C₂C₅ | 126-128 | farblose Nadeln | 3) |
| (CH₂)₂CH₃ | 100-102 | " " | 4) |
| (CH₂)₄CH₃ | 86- 87 | " " | 3) |
| (CH₂)₆CH₃ | 73- 74 | " " | 5) |
| (CH₂)₈CH₃ | 77- 79 | " " | 3) |
| (CH₂)₁₆CH₃ | 91- 93 | " " | 5) |
| C₆H₅ | 139-141 | hellgelbe Nadeln | 6) |

| | | | |
|---|---|---|---|
| 1) H.Gross, A.Rieche, G.Matthey, Chem.Ber. 96, 308 (1963) | | | |
| 2) I.C.Badhwar,K.Venkataraman, Org.Syntheses, Coll. Vol II/304 | | | |
| 3) NG.PH.Buu-Hoi; J.org.Chem. 18, 1723 (1953) | | | |
| 4) W.Campbell, G.M.Coppingen, J.Am.Soc. 73, 2708 (1951) | | | |
| 5) R.D.Haworth, D. Woodcock, J.Chem.Soc. 1946, II,999 | | | |
| 6) Handelsprodukt , Riedel de Häen, Deutschland | | | |

Einige der 5,5'-Diacyl-2,3,4,2',3',4'-hexahydroxy-diphenylmethane sind in der folgenden Tabelle 3 aufgelistet.

**Tabelle 3:**

| R | Fp (°C) | | Ausbeute beute % |
|---|---|---|---|
| H | > 250(Z) | farbloses Pulver | 65 |
| CH₃ | 246-248 | hellgelbes " | 94 |
| C₂H₅ | 234-236 | farbloses " | 68 |
| (CH₂)₂CH₃ | 180-182 | " " | 65 |
| (CH₂)₄CH₃ | 169-171 | " " | 62 |
| (CH₂)₆CH₃ | 157-159 | " " | 61 |
| (CH₂)₈CH₃ | 147-148 | " " | 67 |
| (CH₂)₁₆CH₃ | 137-139 | " " | 65 |
| C₆H₅ | 227-228 | hellgelbe Nadeln | 83 |

Die Konzentration der erfindungsgemäßen o-Naphthochinondiazidsulfonsäureester nach Formel A in dem lichtempfindlichen Gemisch bzw. der lichtempfindlichen Schicht kann in relativ weiten Grenzen schwanken. Im allgemeinen liegt der Anteil bei 3 bis 50, vorzugsweise zwischen 7 und 30 %, bezogen auf den Gehalt an nichtflüchtigen Bestandteilen.

Wie eingangs erwähnt enthalten die erfindungsgemäßen lichtempfindlichen Gemische ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich auch in den erfindungsgemäßen Gemischen als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z.B. Kresolen und Xylenolen als Formaldehyd-Kondensationspartner. Vorzugsweise enthält deshalb das lichtempfindliche Gemisch als alkali-lösliches Bindemittel einen Phenolharz-Novolak.

Als Bindemittel sind auch geeignet: Polyhydroxystyrol, substituierte Polyhydroxystyrole und Polybrenzkatechinmethacrylat. Als weitere alkali-lösliche bzw. in Alkali quellbare Bindemittel sind natürliche Harze, wie Schellack und Kolophonium und synthetische Harze, wie Mischpolymerisate aus Styrol und Maleinsäureanhydrid oder Mischpolymerisate der Acrylsäure oder Methacrylsäure, insbesondere mit Acryl- oder Methacrylsäureestern, zu nennen. In Frage kommen auch Harze, die Succinimid- oder Sulfonamidgruppen enthalten.

Die Art und Menge des alkalilöslichen Harzes kann je nach Anwendungszweck verschieden sein; bevorzugt werden Anteile am Gesamtfeststoff zwischen 97 und 50, besonders bevorzugt 93 - 70, Gewichtsprozent. Zusätzlich können noch zahlreiche andere Harze mitverwendet werden, bevorzugt Epoxide und Vinylpolymerisate wie Polyvinylacetate, Polyacrylate, Polyvinylacetale, Polyvinylether, Polyvinylpyrrolidone und die Mischpolymerisate der ihnen zugrunde liegenden Monomeren. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gewichtsprozent vom alkalilöslichen Harz. In geringen Mengen kann das lichtempfindliche Gemisch für spezielle Erfordernisse wie Flexibilität, Haftung und Glanz, Färbung und Farbumschlag etc. außerdem noch Substanzen wie Polyglykole, Cellulosederivate wie Ethylcellulose, Netzmittel, Farbstoffe, Haftvermittler, Vernetzungsmittel und feinteilige Pigmente sowie bei Bedarf UV-Absorber enthalten.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone wie Methylethylketon, Cyclopentanon und Cyclohexanon, chlorierte Kohlenwasserstoffe wie 1,1,1- und 1,1,2-Trichlorethan, Alkohole wie n-Propanol, Ether wie Tetrahydrofuran, Glykolhalbether wie Ethylenglykolmonoethylether und Propylenglykolmonomethylether, Alkoholetheracetate wie Propylenglykolmethyletheracetat und Ester wie Ethyl- und Butylacetat sowie aromatische Kohlenwasserstoffe wie Toluol und Xylol. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren. Glykolhalbether, insbesondere Ethylenglykolmonomethylether und Propylenglykolmonomethylether sowie Glykoletheracetate, wie Propylenglykolmonomethylether-acetat, werden besonders bevorzugt.

Eine Beschichtungslösung zur Herstellung eines Photoresists ist vorzugsweise so beschaffen, daß der im Lösemittel bzw. Lösemittelgemisch gelöste Gesamtgehalt an nichtflüchtigen Bestandteilen 15 bis 40 Gewichtsprozent beträgt.

Die Erfindung betrifft auch ein lichtempfindliches Kopiermaterial aus einem Schichtträger und einer lichtempfindlichen Schicht aus einem Gemisch nach Anspruch 1.

Als Träger für Schichten mit einer Dicke von weniger als ca. 10 µm werden meist Metalle verwendet. Für Offsetdruckplatten wird insbesondere walzblankes, mechanisch oder elektrochemisch aufgerauhtes und gegebenenfalls anodisiertes Aluminium, das zudem noch chemisch, z.B. mit Polyvinylphosphonsäure, Silikaten, Phosphaten, Hexafluorsilikaten oder mit hydrolysiertem Tetraethylorthosilikat, vorbehandelt sein kann, eingesetzt. Außerdem können Mehrmetallplatten, wie aus Al/Cu/Cr oder aus Messing/Chrom eingesetzt werden. Für die Herstellung von Hochdruckplatten können die erfindungsgemäßen Gemische auf Zink- oder Magnesium-Platten sowie deren handelsübliche mikrokristalline Legierungen für Einstufenätzverfahren aufgetragen werden, außerdem auf ätzbare Kunststoffe, wie Polyoxymethylen. Für Tiefdruck- oder Siebdruckformen eignen sich die erfindungsgemäßen Gemische durch ihre gute Haftung und Ätzfestigkeit auf Kupfer- und Nickeloberflächen. Ebenso lassen sich die erfindungsgemäßen Gemische als Photoresists in der Leiterplattenfertigung und beim Formteilätzen verwenden. Geeignete Schichtträger für Photoresists, die in der Mikrolithographie für Wafer verwendet werden, sind beispielsweise Silicium, Siliciumdioxid, dotiertes Siliciumdioxid, Siliciumnitrid, Polysilicium, Aluminium, Aluminiumlegierungen, Kupfer, Tantal oder polymere Harze.

Für weitere Anwendungen kommen auch andere Schichtträger wie Holz, Papier, Keramik, Textil und andere Metalle in Betracht.

Bevorzugte Schichtträger für dicke Schichten über 10 µm sind Kunststoff-Folien, die dann als temporäre Träger für Transferschichten dienen. Dafür und für Farbprüffolien werden Polyesterfolien, z.B. aus Polyethylenterephthalat, bevorzugt verwendet. Polyolefinfolien wie Polypropylen sind jedoch ebenfalls geeignet.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag. Schließlich kann die Beschichtung von Leiterplatten, Glas oder Keramik und Silicium-Scheiben auch durch Schichtübertragung von einem temporären Schichtträger erfolgen.

Belichtet wird mit den in der Technik üblichen Lichtquellen. Auch die Exponierung mit Elektronen- oder Laserstrahlen stellt eine Möglichkeit zur Bebilderung dar.

Der Gesamtalkaligehalt der für die Entwicklung verwendeten wäßrigen Lösungen liegt bei ca. 1 mol/l, vorzugsweise jedoch zwischen 0,2 und 0,7 mol/l.

Die Entwickler können auch kleinere Mengen organischer Lösemittel oder Netzmittel enthalten. Nach dem Belichten werden die vom Licht getroffenen Stellen der lichtempfindlichen Schicht entfernt, wodurch ein positives Abbild der Vorlage erzeugt wird. Bei dem sogenannten "Bildumkehrprozeß" wird nach der bildmäßigen Belichtung die latente Kopie einer Wärmebehandlung unterworfen. Anschließend belichtet man ganzflächig und entwickelt, wodurch die bei der ganzflächigen Zweitbelichtung vom Licht getroffenen Stellen mit Entwickler entfernt werden. Auf diese Weise erhält man ein negatives Abbild der Vorlage.

Bevorzugte Anwendungen finden die erfindungsgemäßen lichtempfindlichen Gemische bei der Herstellung von Druckformen, d.h. insbesondere für Offset-, autotypischen Tiefdruck- und Siebdruckformen, für Photoresists in der Mikrolithographie und für sogenannte Trockenresists für die Leiterplattenfertigung.

Die unter Verwendung der erfindungsgemäßen Gemische hergestellten Aufzeichnungsmaterialien besitzen eine hohe praktische Lichtempfindlichkeit und eine sehr gute Entwicklerresistenz gegenüber alkalischen Entwicklern. Sie lassen sich auch mit wäßrigen, schwach-alkalischen Lösungen schnell und problemlos entwickeln. Sie sind aber auch hervorragend mit wäßrigen Tetramethylammoniumhydroxid-Lösungen, die keine weiteren entwicklungsfördernden Zusätze enthalten müssen, rückstandsfrei entwickelbar.

Druckformen, die mit diesen lichtempfindlichen Gemischen hergestellt werden, besitzen eine hohe Resistenz gegenüber alkoholhaltigen Feuchtwässern, wie sie heute üblicherweise während des Druckvorganges an Druckmaschinenen verwendet werden.

Photoresists in der Mikrolithographie, die mit diesen lichtempfindlichen Gemischen hergestellt werden, zeichnen sich durch hohe Lichtempfindlichkeit und hohe thermische Stabilität der entwickelten Resiststrukturen aus.

Die bevorzugten Verbindungen selbst zeichnen sich durch gute Löslichkeit in den üblichen für die Beschichtung von Schichtträgern verwendeten Lösemitteln aus und zeigen außerdem eine starke Oleophilie. Die Verbindungen sind weiterhin mit den übrigen Bestandteilen der lichtempfindlichen Schicht gut verträglich.

Die Erfindung wird an Hand der folgenden Beispiele näher erläutert, in denen Gewichtsteile (Gt) und Volumenteile (Vt) im Verhältnis von g zu ml stehen. Prozente sind, wenn nichts anderes angegeben ist, Gewichtsprozente.

### Synthesebeispiel

Die Herstellung von Verbindungen gemäß der allgemeinen Formel A wird im folgenden näher beschrieben.

3,48 g (0,01 mol) 5,5'-Diacetyl-2,3,4,2',3',4'-hexahydroxy-diphenylmethan und 13,43 g (0,05 mol) 1,2-Naphthochinon-2-diazid-5-sulfonylchlorid werden in einem Lösemittelgemisch aus 150 ml Aceton und 70 ml N-Methyl-2-pyrrolidon bei 20 - 24 °C gelöst und in die gelbe Lösung 10,1 g (0,1 mol) N-Methyl-morpholin eingetropft, wobei die Temperatur des Reaktionsgemisches auf 29 - 31 °C ansteigt. Zur Vervollständigung der Reaktion wird noch 35 min nachgerührt. Der Endpunkt der Reaktion ist erreicht, sobald kein 1,2-Naphthochinon-2-diazid-5-sulfonylchlorid mehr nachweisbar ist (Kontrolle durch Dünnschichtchromatographie [DC]). Anschließend wird die braune Lösung unter kräftigem Rühren in ein Gemisch aus 1,5 1 Wasser und 15 ml 37 %-iger Salzsäure innerhalb 40 - 45 min eingetropft. Der hellgelbe amorphe Niederschlag wird abgesaugt, mit 500 ml Wasser auf der Filternutsche gewaschen und 48 h im Vakuumtrockenschrank bei 30 - 40 °C/250 Torr bis zur Gewichtskonstanz getrocknet.

Ausbeute: 14,75 g (= 97,6 % der Theorie); stöchiometrischer Veresterungsgrad: 83,3 % (Verbindung 8 der Tabelle A) ; Anteil an 5,5'-Diacetyl-2,3,4,2',3',4'-hexahydroxydiphenylmethanhexaester: 70,14 % (bestimmt durch Hochdruckflüssigkeitschromatographie [HPLC]).

Nach der gleichen Verfahrensweise erhält man die Verbindung Nr. 23 der Tabelle A, nur werden anstelle von 5,5'-Diacetyl-2,3,4,2',3',4'-hexahydroxy-diphenylmethan 4,72 g (0,01 mol) 5,5'-Dibenzoyl-2,3,4,2',3',4'-hexahydroxy-diphenylmethan, 8,06 g (0,03 mol) 1,2-Naphthochinon-2-diazid-5-sulfonylchlorid und 3,6 g (0,0032 mol) 1,4-Diaza-bicyclo[2.2.2]octan (^{(R)} Dabco) als HCl-Akzeptor verwendet.

Ausbeute: 10,78 g (= 92,3 % der Theorie); stöchiometrischer Veresterungsgrad: 50 %; Anteil an 5,5'-Dibenzoyl-2,3,4,2',3',4'-hexahydroxy-diphenylmethan: 31,0 % (HPLC).

Analog wurden die in der Tabelle A aufgelisteten Verbindungen hergestellt, wobei zur Erzielung des gewünschten Veresterungsgrades die entsprechenden 5,5'-Diacyl-2,3,4,2',3',4'-hexahydroxy-diphenylmethane (Tabelle 3) und die o-Naphthochinondiazidsulfonylchloride in stöchiometrisch berechneter Menge eingesetzt wurden.

Wird Triethylamin oder Triethanolamin als Säureakzeptor eingesetzt, erhält man Verbindungen mit ähnlicher Esterverteilung und vergleichbarem Hexaesteranteil.

Die vom Stand der Technik her bekannten o-Naphthochinondiazidsulfonsäureester 01 - 03 der Tabelle A mit einem stöchiometrischen Veresterungsgrad von 100 % wurden durch Veresterung von 5,5'-Diacetyl-2,3,4,2',3',4'-hexahydroxy-diphenylmethan bzw. 5,5'-Dibenzoyl-2,3,4,2',3',4'-hexahydroxy-diphenylmethan mit 6 mol 1,2-Naphthochinon-2-diazid-5-sulfonsäurechlorid (Verb. 01 und 02) bzw. durch Veresterung von 2,3,4-Trihydroxybenzo-phenon mit 3 mol 7-Methoxy-1,2-naphthochinon-2-diazid-4-sulfonsäurechlorid (Verb.03) analog der für die erfindungsgemäßen Verbindungen angewandten Verfahrensweise synthetisiert. Auf die gleiche Weise wurde durch partielle Veresterung von 2,3,4-Trihydroxybenzophenon mit 1,4 mol 1,2-Naphthochinon-2-diazid-5-sulfonsäurechlorid die bekannte Verbindung 04 erhalten.

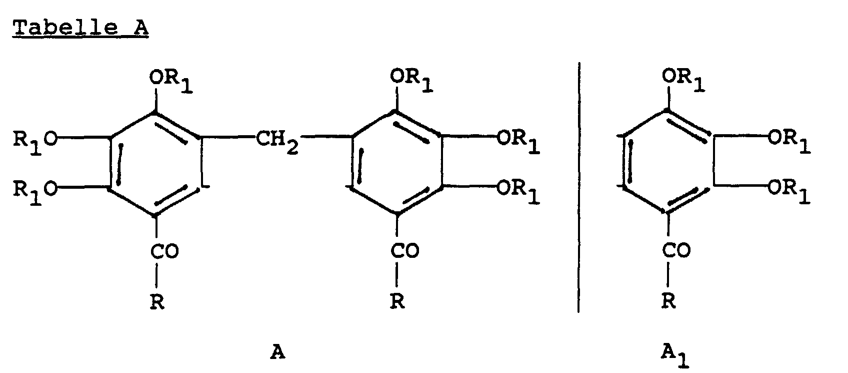

R₁ steht für 1,2-Naphthochinon-2-diazid-5-sulfonyl (D₁), 1,2-Naphtochinon-2-diazid-4-sulfonyl (D₂) oder 7-Methoxy-1,2-naphthochinon-2-diazid-4-sulfonyl (D₃)

| Nr. | R | R₁ | VG/mol (%)¹⁾ | allgemeine Formel |
|---|---|---|---|---|
| 1 | H | D₁ | 66,6 | A |
| 2 | CH₃ | D₁ | 40,0 | A |
| 4 | CH₃ | D₁ | 56,6 | A |
| 8 | CH₃ | D₁ | 83,3 | A |
| 11 | CH₃ | D₂ | 53,3 | A |
| 13 | CH₃ | D₂ | 83,3 | A |
| 16 | CH₃ | D₃ | 83,3 | A |
| 17 | CH₃ | D₃ | 91,6 | A |
| 18 | C₂H₅ | D₁ | 66,6 | A |
| 22 | C₆H₅ | D₁ | 40,0 | A |
| 23 | C₆H₅ | D₁ | 50,0 | A |
| 26 | C₆H₅ | D₁ | 83,3 | A |
| 28 | C₆H₅ | D₂ | 50,0 | A |
| 29 | C₆H₅ | D₂ | 83,3 | A |
| 01 | CH₃ | D₁ | 100,0 | A |
| 02 | C₆H₅ | D₁ | 100,0 | A |
| 03 | C₆H₅ | D₃ | 100,0 | A₁ |
| 04 | C₆H₅ | D₁ | 40,0 | A₁ |

| | | | | |
|---|---|---|---|---|
| 1) stöchiometrischer Veresterungsgrad | | | | |

Die überlegenen Eigenschaften der erfindungsgemäßen Verbindungen 1,4,8,11,13,16,17,18,23,26,28 und 29 der Tabelle A, die mit den entsprechenden Verbindungen der Tabelle 1 identisch sind, gegenüber den bekannten Verbindungen 01 - 04 und den Verbindungen 2 und 22 der Tabelle A werden in den folgenden Beispielen aufgezeigt.

### Beispiel 1

Eine in Salzsäure elektrolytisch aufgerauhte (R_{z}-Wert nach DIN 4768:5,0 µ), jeweils in Schwefelsäure zwischengebeizte und eloxierte (Oxidgewicht 4,0 g/m²) Aluminiumfolie der Stärke 0,3 mm wird mit Polyvinylphosphonsäure entsprechend DE-A 16 21 478 hydrophiliert und dann mit folgender Kopierlacklösung schleuderbeschichtet:

| | |
|---|---|
| 5,00 Gew.-% | Kresol-Formaldehyd-Novolakharz mit einer Hydroxylzahl von 420 nach DIN 53783/ 53240 und einem Gewichtsmittelwert nach GPC von 10 000 (Polystyrol-Standard), |
| .... Gew.-% | Naphthochinondiazidverbindung entsprechend Tabelle A/1 (M), |
| 0,15 Gew.-% | 1,2-Naphthochinon-2-diazid-4-sulfonylchlorid, |
| 0,05 Gew.-% | Victoriareinblau (C.I.44045) und |
| ad 100 Gew.-% | eines Lösemittelgemisches aus Methylethylketon und Propylenglykolmonomethylether (40/60). |

Der Kopierlackfilm wird 1 min bei 125 °C getrocknet. Das Filmgewicht beträgt 2,0 g/m².

Folgende Prüfkriterien werden bei der weiteren Verarbeitung der gefertigten Flachdruckplatten bewertet:

### Lichtempfindlichkeit (LE) :

Die Platten werden mit einer 5 kW-Metallhalogenid dotierten Quecksilberdampflampe im Abstand von 110 cm unter einem UGRA-Offsettestkeil 1982 als Vorlage 45 s lang belichtet und dann 30 s lang in folgenden Entwickler getaucht:

| | |
|---|---|
| Kaliumsilikat | 2,7 Gew.-% |
| Kaliumdisilikat | 1,0 Gew.-% |
| Trikaliumphosphat | 0,5 Gew.-% |
| Triethylenglykol | 0,1 Gew.-% |
| Wasser | 95,7 Gew.-% |

Der Gesamtalkaligehalt beträgt 0,53 mol/l.

Ermittelt wird die offene Halbtonstufe des Testkeils, d.h. diejenige Stufe, bei der erstmals die densitometrisch mit Cyan-Filter gemessene optische Dichte kleiner oder gleich 0,01 ist.

### Entwicklerresistenz (ER) :

Es wird die Anzahl der Halbtonstufen ermittelt, um die Keilwiedergabe bei einer um 4 min verlängerten Entwicklungszeit und ansonsten identischen Bedingungen offener wird.

### Isopropanolresistenz (IR) :

Die unbelichteten Platten werden für 1 min folgender Testlösung ausgesetzt:

| | |
|---|---|
| Isopropanol | 49 Gew.-% |
| Phosphorsäure | 2 Gew.-% |
| Wasser | 49 Gew.-% |

Ermittelt wird der prozentuale Schichtabtrag in der Testlösung.

In Tabelle A/1 bedeuten:
R₁ Anzahl der 1,2-Naphthochinon-2-diazid-5-sulfonyl-Reste,
VG stöchiometrischer Veresterungsgrad,
M in einer Konzentrationsreihe ermittelte Diazomenge zur Erreichung einer offenen Stufe 5 bei der LE-Prüfung (s.o.),
1) Vergleich entsprechend DE-C 938 233,
2) Vergleich entsprechend EP-B 052 788

**Tabelle A/1**

| Beispiel | Verb. Nr. | Formel | R | R₁ | VG % | M | ER | IR |
|---|---|---|---|---|---|---|---|---|
| 1-1 | 04 | A₁ | Phenyl | 1,2 | 40 | 1,30 | 2,5 | 82 1) |
| 1-2 | 02 | A | " | 6,0 | 100 | 0,45 | 4,0 | 92 2) |
| 1-3 | 23 | A | " | 3,0 | 50 | 1,15 | 2,5 | 20 |

Die Ergebnisse entsprechend Tabelle A/1 zeigen, daß mit dem erfindungsgemäßen Naphthochinondiazid 23 eine Verbesserung der Isopropanolresistenz von Positivkopierlackfilmen, welche auf die Verarbeitbarkeit mit schwach-alkalischen Entwicklern hin abgestimmt sind, unter Beibehaltung der Lichtempfindlichkeit möglich ist.

### Beispiel 2

Eine in Salpetersäure elektrolytisch aufgerauhte (Rz-Wert nach DIN 4768: 2,8 µm ) und in Schwefelsäure eloxierte (Oxidgewicht 3,0 g/m²) Aluminiumfolie der Stärke 0,3 mm wird mit Polyvinylphosphonsäure entsprechend DE-A 16 21 478 hydrophiliert und dann mit folgender Kopierlacklösung auf einer Schleuder beschichtet:

| | |
|---|---|
| 5,00 Gew.-% | Kresol-Formaldehyd-Novolakharz mit einer Hydroxylzahl von 420 nach DIN 53783/53240 und einem Gewichtsmittelwert nach GPC von 10 000 (Polystyrol-Standard), |
| .... Gew.-% | Naphthochinondiazidverbindung entsprechend Tabelle A/2 (M), |
| 0,15 Gew.-% | 1,2-Naphthochinon-2-diazid-4-sulfonylchlorid, |
| 0,08 Gew.-% | Victoriareinblau (C.I. 44045) und |
| ad 100 Gew.-% | eines Lösemittelgemisches aus Tetrahydrofuran und Proplyenglykolmonomethylether (55/45). |

Der Kopierlackfilm wird 1 min bei 125 °C getrocknet. Das Filmgewicht beträgt 2,2 g/m².

Bei der weiteren Verarbeitung der gefertigten Flachdruckplatten werden dieselben Prüfkriterien wie in Beispiel 1 bewertet.

In Tabelle A/2 bedeuten:
R₁ Anzahl der 1,2-Naphthochinon-2-diazid-5-sulfonyl-Reste,
VG stöchiometrischer Veresterungsgrad,
M in einer Konzentrationsreihe ermittelte Diazomenge zur Erreichung einer offenen Stufe 5 bei der LE-Prüfung (s.o.),
1) Vergleich entsprechend DE-C 938 233 (Formel A₁)

**Tabelle A/2**

| Beispiel | Verb. Nr. | Formel | R | R₁ | VG % | M | ER | IR |
|---|---|---|---|---|---|---|---|---|
| 2-1 | 04 | A₁ | Phenyl | 1,2 | 40 | 1,30 | 2,5 | 82 1) |
| 2-2 | 1 | A | Wasserstoff | 4,0 | 66,6 | 1,20 | 3,5 | 7 |
| 2-3 | 4 | A | Methyl | 3,4 | 56,6 | 1,60 | 3,0 | 2 |
| 2-4 | 18 | A | Ethyl | 4,0 | 66,6 | 1,10 | 2,5 | 25 |

Die Ergebnisse mit den erfindungsgemäßen Naphthochinondiaziden 1, 4 und 18 aus Tabelle A/2 bestätigen das Ergebnis der besseren Isopropanolresistenz aus Beispiel 1.

### Beispiel 3

Eine in Salzsäure elektrolytisch aufgerauhte (Rz-Wert nach DIN 4768:4,2 µm ), in Schwefelsäure zwischengebeizte und in Schwefelsäure eloxierte (Oxidgewicht 3,0 g/m²) Aluminiumfolie der Stärke 0,3 mm wird mit Polyvinylphosphonsäure entsprechend DE-A 16 21 478 hydrophiliert und dann mit folgender Kopierlacklösung beschichtet:

| | |
|---|---|
| 4,80 Gew.-% | Kresol-Formaldehyd-Novolakharz mit einer Hydroxylzahl von 420 nach DIN 53783/53240 und einem Gewichtsmittelwert nach GPC von 10 000 (Polystyrol-Standard), |
| .... Gew.-% | 1,2-Naphthochinon-2-diazid-4-sulfonyl-Verbindung entsprechend Tabelle A/3 (M), |
| 0,05 Gew.-% | 2-(4-Styrylphenyl)-4,6-bis-trichlormethyl-s-triazin, |
| 0,10 Gew.-% | Kristallviolett (C.I. 42555), und |
| ad 100 Gew.-% | eines Lösemittelgemisches aus Tetrahydrofuran und Proplyenglykolmonomethylether (55/45). |

Der Kopierlackfilm wird 1 min bei 125 °C getrocknet. Das Filmgewicht beträgt 1,8 g/m².

Geprüft wird in diesem Beispiel die Eignung der erfindungsgemäßen Naphthochinondiazidverbindungen für die Umkehrverarbeitung, d.h. die Positiv-Negativ-Konvertierung.

Hierzu werden die Platten wie in Beispiel 1 belichtet, dann 2 min in einem Ofen bei 135 °C getempert, nach Abkühlen ohne Vorlage ausbelichtet und in dem Entwickler aus Beispiel 1 30 s lang entwickelt. Mit den so gefertigten Flachdruckplatten wird in einer Bogenoffsetdruckmaschine mit einem Alkoholfeuchtwerk bei einem Isopropanolgehalt des Feuchtwassers von 25 % ein Druckauflagentest durchgeführt.

Die Ergebnisse sind in Tabelle A/3 zusammengestellt.

In Tabelle A/3 bedeuten:
R₁ Anzahl der 1,2-Naphthochinon-2-diazid-4-sulfonyl-Reste,
VG stöchiometrischer Veresterungsgrad,
M eingesetzte Diazomenge,
LE Lichtempfindlichkeit, d.h. die voll gedeckte Stufe des UGRA-Offsettestkeils,
DRA Druckauflage im Alkoholfeuchtwerk,
1) Vergleich entsprechend DE-C 938 233 (Formel A₁)

**Tabelle A/3**

| Beispiel | Verb. Nr. | Formel | R | R₁ | VG % | M | LE | DRA |
|---|---|---|---|---|---|---|---|---|
| 3-1 | 04 | A₁ | Phenyl | 1,2 | 40 | 1,30 | 2 | 70000 1) |
| 3-2 | 11 | A | Methyl | 3,2 | 53,3 | 1,20 | 2 | 80000 |
| 3-3 | 28 | A | Phenyl | 3,0 | 50 | 1,2 | 2 | 80000 |

Die Ergebnisse entsprechend Tabelle A/3 zeigen, daß mit den erfindungsgemäßen Naphtochinondiaziden 11 und 28 auch die Umkehrverarbeitung möglich ist und daß die Druckauflagenleistung in Alkoholfeuchtwerken derjenigen von mit der bekannten Naphthochinondiazidverbindung 04 gefertigten Flachdruckplatten überlegen ist.

### Beispiel 4

### Löslichkeit

Die Löslichkeit der erfindungsgemäßen photoaktiven Verbindung wird in einer 25 %-igen Lösung eines Kresol/Xylenol-Novolaks in l-Methoxy-2-propylacetat (PGMEA) bestimmt, da die entstehenden Lösungen der Realität eines Photoresistgemisches weit mehr entsprechen, als Lösungen der erfindungsgemäßen Verbindungen in reinem PGMEA.

Durch Zugabe eines Überschusses der photoaktiven Verbindung zu der angegebenen Novolak-Lösung werden gesättigte Lösungen dieser Verbindungen hergestellt. Die UV-Absorption dieser Lösungen bei λₘₐₓ wird bestimmt und durch Vergleich mit einer UV-Eichgeraden, erhalten aus verdünnten Lösungen der entsprechenden Verbindungen, die Konzentration der gesättigten Lösungen ermittelt.

Auf diesem Weg wird die Löslichkeit der Verbindung 8 mit 28 % (bezogen auf den Feststoffanteil der Lösung), die Löslichkeit der Verbindung 13 mit 46 %, die Löslichkeit der Verbindung 17 mit 45 % und die Löslichkeit der Verbindung 29 mit 39 % ermittelt, während die Löslichkeit der Vergleichsverbindung 01 nur 22 % beträgt.

Da bei hochauflösenden Photoresistformulierungen ein möglichst großer Gehalt an photoaktiver Verbindung angestrebt wird, kommt der Löslichkeit dieser Komponente eine Schlüsselstellung zu.

### Beispiel 5

### Lichtempfindlichkeit

In eine 21 %-ige Lösung eines Kresol/Xylenol-Novolaks in l-Methoxy-2-propylacetat (PGMEA) werden, bezogen auf den Feststoffgehalt der Novolaklösung, jeweils 33,3 Gew.-% der photoaktiven Verbindungen 16, 17 und 03 der Tabelle A eingetragen und gelöst.

Mit diesen Resistlösungen werden Silicium-Wafer durch Aufschleudern beschichtet und die so erhaltenen Schichten auf einer Heizplatte 45 s lang bei einer Temperatur von 100 °C getrocknet. Die Schichtdicke beträgt 1,25 µm.

Danach erfolgt die Belichtung des Photoresists auf dem Wafer in unterschiedlichen Belichtungsdosen mit der g-Linie des Lichtes einer Quecksilberhochdrucklampe aus einem in der Technik üblichen Belichtungsgerät (g-line Stepper).

Anschließend werden die so belichteten Scheiben einer nochmaligen Wärmebehandlung von 120 °C 45 s lang ausgesetzt und danach in einer wäßrigen Lösung aus Tetramethylammoniumhydroxyd (N = 0,27 mol/l) 30 s lang entwickelt. Die belichteten Felder werden entsprechend ihrer Belichtungsdosis unterschiedlich schnell entwickelt. Verglichen wird die benötigte Energiedosis an dem gerade aufentwickelten Belichtungsfeld, dem sog. Aufpunkt.

Zur Erreichung des Aufpunktes benötigt die die Verbindung 17 enthaltene Resistschicht 42 mJ/cm², die Resistschicht mit Verbindung 16 58 mJ/cm² und die Resistschicht mit der Vergleichsverbindung 03 92 mJ/cm². Das entspricht einer Steigerung der Lichtempfindlichkeit, definiert als der reziproke Energiebedarf, bei der Verbindung 17 um 119 % und bei der Verbindung 16 um 59 %.

Unter analogen Bedingungen - nur die Entwicklungszeit wurde auf 50 s verlängert - wurde eine Reihe weiterer lichtempfindlicher Lösungen verglichen, wobei die Belichtung der Photoresists mit der i-Linie des Lichtes einer Quecksilberhochdrucklampe eines in der Technik üblichen Belichtungsgerätes erfolgte (i-line Stepper). Zur Erreichung des Aufpunktes benötigte die die Verbindung 13 enthaltende Resistschicht 30 mJ/cm², die Resistschicht mit der Verbindung 16 40 mJ/cm², die Resistschicht mit der Verbindung 29 58 mJ/cm² und die Resistschicht mit der Vergleichsverbindung 03 69 mJ/cm². Das entspricht einer Steigerung der Lichtempfindlichkeit, definiert als der reziproke Energiebedarf, bei der Verbidnung 13 um 130 %, bei der Verbindung 16 um 73 % und bei der Verbindung 29 um 19 %.

### Beispiel 6

### Thermische Stabilität

Mit den Resistlösungen aus Beispiel 5 werden Silicium-Wafer durch Aufschleudern beschichtet und die so erhaltenen Schichten auf einer auf 90 °C erwärmten Heizplatte 45 s lang getrocknet. Die Schichtdicke beträgt 1,25 µm. Nach der Belichtung mit Licht der Wellenlänge = 436 nm mit einem in der Technik üblichen Belichtungsgerät durch eine Maske, die Strukturen unterschiedlicher Dimensionen enthält, werden die Wafer einer nochmaligen Wärmebehandlung von 45 s auf einer auf 100 °C erwärmten Heizplatte ausgesetzt.

Anschließend löst man die vom Licht getroffenen Bereiche der Schicht mit einer wäßrigen Lösung aus Tetramethylammoniumhydroxyd (N = 0,24 mol/l) ab (Entwicklungszeit 30 s), so daß die nicht belichteten Flächenanteile auf der Silicium-Scheibe zurückbleiben.

Um die Wärmestabilität der Strukturen zu testen, werden die so prozessierten Silicium-Scheiben Temperaturen von jeweils 120 °C, 125 °C, 130 °C und 135 °C für eine Zeitdauer von je 60 s ausgesetzt und anschließend im Rasterelektronenmikroskop ausgewertet.

Die vergleichenden Untersuchungen ergaben, daß mit der Resistlösung der erfindungsgemäßen photoaktiven Verbindung 16 strukturstabile 2 µm-Linien bis zu einer Temperatur von 130 °C zu erreichen sind, während bei Verwendung der Resistlösung mit der Vergleichsverbindung 03 die 2 µm-Linien nur bis zu einer Temperatur von 120 °C strukturstabil sind.

### Beispiel 7

Eine in Salpetersäure elektrolytisch aufgerauhte (R_{z}-Wert nach DIN 4768: 2,8 µm ) und in Schwefelsäure eloxierte (Oxidgewicht 3,0 g/m²) Aluminiumfolie der Stärke 0,3 mm wird mit Polyvinylphosphonsäure entsprechend DE-A 16 21 478 hydrophiliert und dann mit folgender Kopierlacklösung auf einer Schleuder beschichtet:

| | |
|---|---|
| 5,00 Gew.-% | Kresol-Formaldehyd-Novolakharz mit einer Hydroxylzahl von 420 nach DIN 53783/53240 und einem Gewichtsmittelwert nach GPC von 10 000 (Polystyrol-Standard), |
| .... Gew.-% | Naphthochinondiazidverbindung entsprechend Tabelle A/4 (M), |
| 0,15 Gew.-% | 1,2-Naphthochinon-2-diazid-4-sulfonylchlorid, |
| 0,08 Gew.-% | Victoriareinblau (C.I. 44045) und |
| ad 100 Gew.-% | eines Lösemittelgemisches aus Tetrahydrofuran und Proplyenglykolmonomethylether (55/45). |

Der Kopierlackfilm wird 1 min lang bei 125 °C getrocknet. Das Filmschichtgewicht beträgt 2,2 g/m².

Bei der weiteren Verarbeitung der gefertigten Flachdruckplatten werden dieselben Prüfkriterien wie in Beispiel 1 bewertet.

In der Tabelle bedeuten:
R₁ Anzahl der 1,2-Naphthochinon-2-diazid-5-sulfonyl-Reste,
VG stöchiometrischer Veresterungsgrad,
M eingesetzte Diazomenge

| Beispiel | Verb. Nr. | Formel | R | R₁ | VG % | M | LE | ER | IR |
|---|---|---|---|---|---|---|---|---|---|
| 7-1 | 2 | A | Methyl | 2,7 | 40 | 1,30 | 5 | >8 | 30 |
| 7-2 | 22 | A | Phenyl | 2,7 | 40 | 1,30 | 5 | >8 | 29 |

Das Beispiel 7 zeigt, daß die mit den Naphthochinondiaziden 2 und 22 hergestellten Kopierschichten zwar eine ausreichende Lichtempfindlichkeit aufweisen, die Entwickler- und Isopropanolresistenz jedoch kaum noch befriedigend ist.

## Patentansprüche

1. Lichtempfindliches Gemisch, das ein wasserunlösliches, in wäßrig-alkalischen Lösungen lösliches oder mindestens quellbares polymeres Bindemittel und einen o-Naphthochinondiazidsulfonsäureester enthält, dadurch gekennzeichnet, daß der 1,2-Naphthochinon-2-diazidsulfonsäureester der allgemeinen Formel I entspricht, 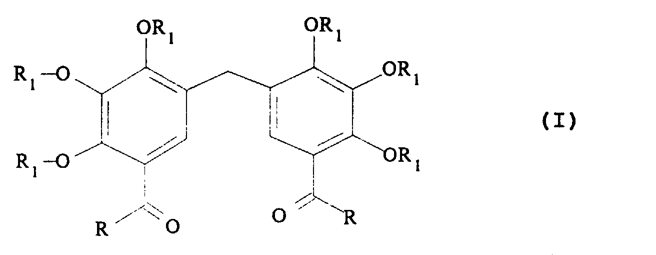 in der
R Wasserstoff, ein Alkyl- oder Arylrest,
R₁ Wasserstoff, ein 1,2-Naphthochinon-2-diazid-4-, 1,2-Naphthochinon-2-diazid-5- oder 7-Methoxy-1,2-naphthochinon-2-diazid-4-sulfonylrest
bedeuten, wobei die Zahl der als R₁ definierten gleichartigen oder unterschiedlichen Naphthochinondiazidsulfonylreste im Molekül 1 bis 5 beträgt und der stöchiometrische Veresterungsgrad bei höchstens 65 % liegt, wenn R für einen Methylrest und R₁ für einen 1,2-Naphthochinon-2-diazid-5-sulfonylrest steht, und wobei 5,5'-Di(C₇-C₁₁)alkanoyl-2,3,4,2',3',4'-hexahydroxy-diphenylmethane, deren Hydroxygruppen zu 60 bis 100 % mit 1,2-Naphthochinon-2-diazid-4-sulfonsäure verestert sind, ausgeschlossen sind.

2. Lichtempfindliches Gemisch gemäß Anspruch 1, dadurch gekennzeichnet, daß es zusätzlich mindestens einen o-Naphthochinondiazidsulfonsäureester der allgemeinen Formel I enthält, in dem sämtliche Gruppen R₁ Naphthochinondiazidreste bedeuten.

3. Lichtempfindliches Gemisch gemäß Anspruch 1 oder 2, dadurch gekennzeichnet, daß die o-Naphthochinon-diazidsulfonsäureester der allgemeinen Formel I durch Umsetzung von 5,5'-Diacyl-2,3,4,2',3',4'-hexahydroxy-diphenylmethan mit weniger als 6 Äquivalenten eines aktivierten o-Naphthochinon-diazidsulfonsäurederivats erhalten sind und der stöchiometrische Veresterungsgrad kleiner als 100 % ist.

4. Lichtempfindliches Gemisch gemäß Anspruch 1 oder 2, dadurch gekennzeichnet, daß der stöchiometrische Veresterungsgrad 40 - 95 % ist.

5. Lichtempfindliches Gemisch gemäß Anspruch 4, dadurch gekennzeichnet, daß R für einen Methyl- oder Phenylrest steht.

6. Lichtempfindliches Gemisch gemäß Anspruch 1 oder 2, dadurch gekennzeichnet, daß R für einen Methylrest, R₁ für einen 1,2-Naphthochinon-2-diazid-5-sulfonylrest steht und der stöchiometrische Veresterungsgrad zwischen 50 und 65 % liegt.

7. Lichtempfindliches Gemisch gemäß Anspruch 1 oder 2, dadurch gekennzeichnet, daß R für einen Phenylrest, R₁ für einen 1,2-Naphthochinon-2-diazid-5-sulfonylrest steht und der stöchiometrische Veresterungsgrad zwischen 45 und 60 % liegt.

8. Lichtempfindliches Gemisch gemäß Anspruch 1 oder 2, dadurch gekennzeichnet, daß R für einen Methylrest, R₁ für einen 7-Methoxy-1,2-naphthochinon-2-diazid-4-sulfonylrest steht und der stöchiometrische Veresterungsgrad zwischen 70 und 95 % liegt.

9. Lichtempfindliches Gemisch nach einem oder mehreren der Ansprüche 1 bis 8, dadurch gekennzeichnet, daß das polymere Bindemittel ein Phenolharz-Novolak ist.

10. Lichtempfindliches Gemisch nach einem oder mehreren der Ansprüche 1 bis 9, dadurch gekennzeichnet, daß der Anteil an 1,2-Naphthochinon-2-diazid-sulfonsäureester gemäß Formel I 3 bis 50 Gew.-% beträgt, bezogen auf das Gesamtgewicht der nichtflüchtigen Bestandteilen.

11. Lichtempfindliches Kopiermaterial aus einem Schichtträger und einer lichtempfindlichen Schicht, dadurch gekennzeichnet, daß die Schicht aus einem Gemisch gemäß einem oder mehreren der Ansprüche 1 bis 10 besteht.

12. Lichtempfindliches Material nach Anspruch 11, dadurch gekennzeichnet, daß der Schichtträger aus Aluminium besteht, dessen Oberfläche mechanisch oder elektrochemisch aufgerauht und gegebenenfalls anodisch oxydiert ist.

13. Lichtempfindliches Material nach Anspruch 11, dadurch gekennzeichnet, daß der Schichtträger aus einer Polyesterfolie besteht.

## Claims

1. Photosensitive mixture which contains a polymeric binder which is insoluble in water, soluble or at least swellable in aqueous/alkaline solutions and contains an o-naphthoquinonediazidesulfonic acid ester, characterised in that the 1,2-naphthoquinone-2-diazidesulfonic acid ester is of the general formula I, 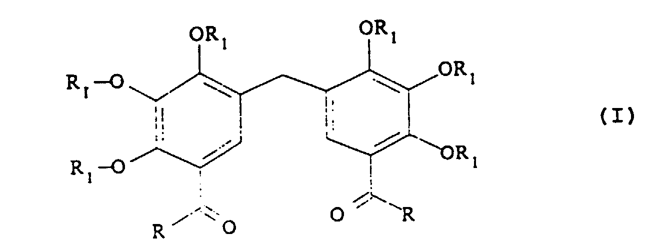 in which
R means hydrogen, an alkyl or aryl residue,
R₁ means hydrogen, a 1,2-naphthoquinone-2-diazide-4-, 1,2-naphthoquinone-2-diazide-5- or 7-methoxy-1,2-naphthoquinone-2-diazide-4-sulfonyl residue,
wherein the number of identical or different naphthoquinonediazidesulfonyl residues defined as R₁ in the molecule is from 1 to 5 and the stoichiometric degree of esterification is at most 65%, if R denotes a methyl residue and R₁ denotes a 1,2-naphthoquinone-2-diazide-5-sulfonyl residue, and wherein 5,5'-di (C₇-C₁₁)alkanoyl-2,3,4,2',3',4'-hexahydroxydiphenylmethanes, 60 to 100% of the hydroxy groups of which are esterified with 1,2-naphthoquinone-2-diazide-4-sulfonic acid, are excluded.

2. Photosensitive mixture according to claim 1,
characterised in that it additionally contains at least one o-naphthoquinonediazidesulfonic acid ester of the general formula I, in which all the groups R₁ mean naphthoquinonediazide residues.

3. Photosensitive mixture according to claim 1 or 2, characterised in that the o-naphthoquinonediazidesulfonic acid esters of the general formula I are obtained by reacting 5,5'-diacyl-2,3,4,2',3',4'-hexahydroxydiphenylmethane with less than 6 equivalents of an activated o-naphthoquinonediazidesulfonic acid derivative and the stoichiometric degree of esterification is less than 100%.

4. Photosensitive mixture according to claim 1 or 2, characterised in that the stoichiometric degree of esterification is 40-95%.

5. Photosensitive mixture according to claim 4, characterised in that R denotes a methyl or phenyl residue.

6. Photosensitive mixture according to claim 1 or 2, characterised in that R denotes a methyl residue, R₁ denotes a 1,2-naphthoquinone-2-diazide-5-sulfonyl residue and the stoichiometric degree of esterification is between 50 and 65%.

7. Photosensitive mixture according to claim 1 or 2, characterised in that R denotes a phenyl residue, R₁ denotes a 1,2-naphthoquinone-2-diazide-5-sulfonyl residue and the stoichiometric degree of esterification is between 45 and 60%.

8. Photosensitive mixture according to claim 1 or 2, characterised in that R denotes a methyl residue, R₁ denotes a 7-methoxy-1,2-naphthoquinone-2-diazide-4-sulfonyl residue and the stoichiometric degree of esterification is between 70 and 95%.

9. Photosensitive mixture according to one or more of claims 1 to 8, characterised in that the polymeric binder is a phenolic resin novolak.

10. Photosensitive mixture according to one or more of claims 1 to 9, characterised in that the content of 1,2-naphthoquinone-2-diazidesulfonic acid esters according to the formula I is 3 to 50 wt.%, relative to the total weight of the non-volatile constituents.

11. Photosensitive reproduction material comprising a layer support and a photosensitive layer, characterised in that the layer consists of a mixture according to one or more of claims 1 to 10.

12. Photosensitive material according to claim 11, characterised in that the layer support consists of aluminium, the surface of which is mechanically or electrochemically roughened and optionally anodically oxidised.

13. Photosensitive material according to claim 11, characterised in that the layer support consists of a polyester film.

## Revendications

1. Mélange photosensible qui contient un liant polymère insoluble dans l'eau, soluble ou au moins gonflable dans des solutions alcalines aqueuses et un ester d'acide o-naphtoquinone diazide sulfonique, caractérisé en ce que l'ester d'acide 1,2-naphtoquinone-2-diazide sulfonique correspond à la formule générale I, 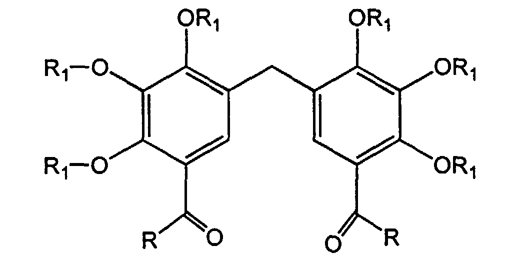 dans laquelle
R signifie l'hydrogène, un radical alkyle ou aryle,
R₁ signifie l'hydrogène, un radical 1,2-naphtoquinone-2-diazide-4-sulfonyle, 1,2-naphtoquinone-2-diazide-5-sulfonyle ou 7-méthoxy-1,2-naphtoqulnone-2-diazide-4-sulfonyle,
le nombre de radicaux naphto quinone diazide sulfonyle identiques ou différents définis pour R₁ s'élevant de 1 à 5 dans la molécule et le degré d'estérification stoechiométrique étant au maximum à 65%, quand R est un radical méthyle et R₁ est un radical 1,2-naphtoquinone-2-diazide-5-sulfonyle, et les 5,5'-di-alcanoyl (en C₇-C₁₁)-2,3,4,2',3',4'-hexahydroxy-diphénylméthanes dont les groupes hydroxy sont estérifiés de 60 à 100% avec l'acide 1,2-naphtoquinone-2-diazide-4-sulfonique, étant exclus.

2. Mélange photosensible selon la revendication 1, charactérisé en ce que le mélange contient de plus un ester d'acide naphtho quinone diazine sulfonique de formule générale I dans laquelle l'ensemble des groupe R₁ signifient des radicaux naphtoquinone diazide.

3. Mélange photosensible selon la revendication 1 ou 2, caractérisé en ce que les esters d'acide o-naphto quinone diazide sulfonique de formule générale I sont obtenus par réaction du 5,5'-diacyl-2,3,4,2',3',4'-hexahydroxydiphénylméthane avec moins de 6 équivalents d'un dérivé d'acide o-naphto quinone diazide sulfonique activé et que le degré d'estérification stoechiométrique est inférieur à 100%.

4. Mélange photosensible selon la revendication 1 ou 2, caractérisé en ce que le degré d'estérification stoechiométrique est 40 - 95%.

5. Mélange photosensible selon la revendication 4, caractérisé en ce que R est un radical méthyle ou phényle.

6. Mélange photosensible selon la revendication 1 ou 2, caractérisé en ce que R est un radical méthyle, R₁ est un radical 1,2-naphtoquinone-2-diazide-5-sulfonyle et que le degré d'estérification stoechiométrique est entre 50 et 65%.

7. Mélange photosensible selon la revendication 1 ou 2, caractérisé en ce que R est un radical phényle, R₁ est un radical 1,2-naphtoquinone-2-diazide-5-sulfonyle et que le degré d'estérification stoechiométrique est entre 45 et 60%.

8. Mélange photosensible selon la revendication 1 ou 2, caractérisé en ce que R est un radical méthyle, R₁ est un radical 7-méthoxy-1,2-naphtoquinone-2-diazide-4-sulfonyle et que le degré d'estérification stoechiométrique est entre 70 et 95%.

9. Mélange photosensible selon une ou plusieurs des revendications 1 à 8, caractérisé en ce que le liant polymère est une résine phénol-novolaque.

10. Mélange photosensible selon une ou plusieurs des revendications 1 à 9, caractérisé en ce que la quantité d'ester d'acide 1,2-naphtoquinone-2-diazide-sulfonique selon la formule I est de 3 à 50% en poids, rapporté au poids total des constituants non volatils.

11. Matériau de copie photosensible constitué d'une couche support et d'une couche photosensible, caractérisé en ce que la couche est constituée d'un mélange selon l'une ou plusieurs des revendications 1 à 10.

12. Matériau photosensible selon la revendication 11, caractérisé en ce que la couche support est constituée d'aluminium, dont la surface est rendue rugueuse mécaniquement ou électrochimiquement et éventuellement oxydée anodiquement.

13. Matériau photosensible selon la revendication 11, caractérisé en ce que la couche support est constituée d'une feuille de polyester.
